# FASCICULE DE BREVET EUROPEEN

(11) **EP 1 786 026 B1**
(45) Date de publication et mention de la délivrance du brevet: **31.07.2013**
(21) Numéro de dépôt: 06354035.5
(22) Date de dépôt: 31.10.2006
(51) Int. Cl.: H01L 21/20

(54) **Procédé de réalisation de premières et secondes zones actives semi-conductrices distinctes et utilisation pour la fabrication de structures de type C-MOS**
Verfahren zum Herstellen von ersten und zweiten unterschiedlichen, aktiven Halbleiterzonen und Verwendung für die Herstellung von CMOS-Strukturen
Method of fabricating first and second separate active semiconductor zones and use for the fabrication of CMOS structures.

(30) Priorité: 09.11.2005 FR 0511424
(43) Date de publication de la demande: 16.05.2007
(73) Titulaire: Commissariat à l'Énergie Atomique et aux Énergies Alternatives, 75015 Paris (FR); STMICROELECTRONICS S.A., 92120 Montrouge (FR)
(72) Inventeur: Barbe, Jean-Charles, 38100 Grenoble (FR); Clavelier, Laurent, 38700 Voiron (FR); Vianay, Benoit, 38000 Grenoble (FR); Morand, Yves, 38000 Grenoble (FR)
(74) Mandataire: Hecké, Gérard

(56) Documents cités:
- US-A- 4 751 561
- US-A- 5 514 885
- US-A1- 2002 019 105
- US-A1- 2002 140 033
- YAOCHENG LIU ET AL: "MOSFETs and high-speed photodetectors on ge-on-insulator substrates fabricated using rapid melt growth" ELECTRON DEVICES MEETING, 2004. IEDM TECHNICAL DIGEST. SAN FRANCISCO, CA, USA DEC. 13-15, 2004, 13 décembre 2004 (2004-12-13), pages 1001-1004, XP010788979 PISCATAWAY, NJ, USA ISBN: 0-7803-8684-1

## Description

### Domaine technique de l'invention

L'invention concerne un procédé de réalisation sur la face avant d'un support de premières et secondes zones actives, respectivement constituées par des premier et second matériaux semi-conducteurs monocristallins distincts et comportant des faces avant coplanaires.

L'invention concerne également l'utilisation d'un tel procédé pour la fabrication de structures de type C-MOS.

### État de la technique

Pour améliorer les performances des circuits intégrés de type C-MOS, on utilise des substrats dits hybrides. De tels substrats supportent deux types de régions actives semi-conductrices. Ainsi, un type de régions actives est destiné à la fabrication de transistors n-MOS tandis que l'autre type est destiné à la fabrication de transistors p-MOS. Les procédés de fabrication actuels de tels substrats hybrides sont relativement complexes et, en conséquence, coûteux.

Par ailleurs, le brevet US 5,514,885 propose un procédé de réalisation d'un substrat hybride destiné à être utilisé lors de la fabrication de circuits tels que les dispositifs à couplage de charge (CCD), les mémoires numériques intégrées, les microprocesseurs et les circuits analogiques intégrés. Le procédé consiste à former des zones actives en GaAs cristallin, à côté de zones actives en silicium monocristallin obtenues en gravant un substrat massif en silicium. Ainsi, la surface d'un substrat massif en silicium monocristallin est structurée, et plus particulièrement gravée, de manière à former, dans le substrat massif en silicium monocristallin, des régions en saillie destinées à constituer des fenêtres de germination pour former les zones actives en GaAs monocristallin. Une couche mince en SiO₂ thermique ou en SiO₂-Al₂O₃ est, ensuite, déposée sur la surface du substrat, puis elle est gravée pour exposer une partie de la paroi supérieure desdites régions en saillie. Une couche en GaAs polycristallin ou amorphe est, alors, déposée sur la surface du substrat recouverte en partie par la couche en SiO₂ thermique ou en SiO₂-Al₂O₃. Puis, une couche de protection diélectrique est déposée sur la couche en GaAs polycristallin ou amorphe, avant qu'une impulsion lumineuse, uniforme dans l'espace, ne soit appliquée pour faire fondre la couche en GaAs polycristallin ou amorphe, en vue d'une recristallisation du GaAs, sous forme monocristalline, à partir des régions en saillie. Une étape de planarisation permet, ensuite, d'obtenir des zones actives en GaAs monocristallin et des zones actives en silicium monocristallin coplanaires. Les zones actives en GaAs monocristallin sont séparées du substrat en silicium monocristallin, et plus particulièrement des zones actives en silicium monocristallin, par la couche en SiO₂ thermique ou en SiO₂-Al₂O₃.

### Objet de l'invention

L'invention a pour but de simplifier la fabrication des substrats hybrides et, en particulier, la fabrication de structures de type C-MOS.

Selon l'invention, ce but est atteint par les revendications annexées.

Plus particulièrement, ce but est atteint par le fait que le support est constitué d'un empilement d'un substrat et d'une couche mince isolante électriquement, la face avant de la couche mince isolante électriquement constituant la face avant du support et en ce que le procédé comporte au moins les étapes successives suivantes :
- formation, sur la face avant de la couche mince isolante électriquement, des premières zones actives dont au moins les parois latérales sont recouvertes par une couche mince de protection,
- structuration de la couche mince de protection de manière à libérer des régions d'interface dans les parois latérales de premières zones actives présélectionnées,
- intercalation entre les premières zones actives, sur la face avant de la couche mince isolante électriquement, de motifs en second matériau semi-conducteur sous forme polycristalline et/ou amorphe, chaque motif comportant au moins une partie d'une paroi latérale en contact direct avec une région d'interface d'une première zone active présélectionnée adjacente et une face avant disposée dans le même plan que les faces avant des premières zones actives,
- dépôt d'une couche de passivation sur les premières zones actives et les motifs,
- et cristallisation du second matériau semi-conducteur sous forme monocristalline, de manière à former les secondes zones actives.

Plus particulièrement, lorsqu'un tel procédé est utilisé pour la fabrication de structures de type C-MOS, les premières et secondes zones actives étant respectivement en silicium et en germanium, des transistors n-MOS sont formés dans les premières zones actives et des transistors p-MOS sont formés dans les secondes zones actives.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

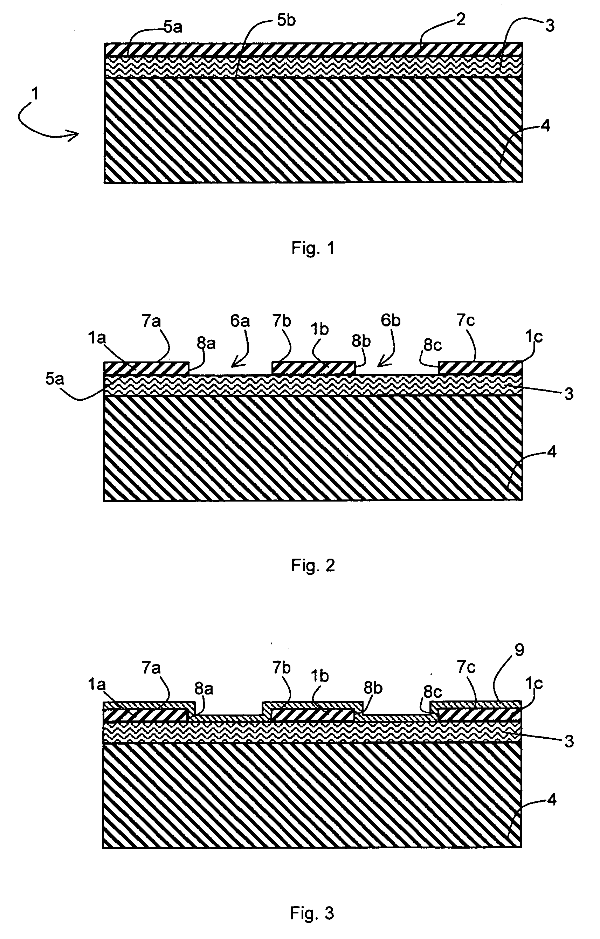

Les figures 1 à 10 représentent, schématiquement, en coupe les différentes étapes d'un mode particulier de réalisation selon l'invention.

### Description de modes particuliers de réalisation

Un procédé selon l'invention permet de réaliser de manière simple et peu coûteuse, sur la face avant d'un support, des premières et secondes zones actives, respectivement constituées par des premier et second matériaux semi-conducteurs monocristallins distincts. De plus, il permet aux faces avant des premières et secondes zones actives d'être dans un même plan et les premier et second matériaux semi-conducteurs ont, de préférence, des structures cristallines identiques.

Un tel procédé consiste notamment à réaliser les secondes zones actives par une étape de cristallisation du second matériau semi-conducteur sous forme monocristalline, à partir de motifs en second matériau semi-conducteur sous forme polycristalline et/ou amorphe et de régions d'interface entre lesdits motifs et des premières zones actives présélectionnées.

Selon un mode particulier de réalisation, l'étape de cristallisation est, de préférence, réalisée par une méthode de solidification localisée. Dans ce cas, le second matériau semi-conducteur a une température de fusion inférieure à celle du premier matériau semi-conducteur. La méthode de solidification localisée est également appelée épitaxie en phase liquide ou LPE (« Liquid-Phase Epitaxy »).

Il a déjà été proposé d'utiliser la méthode de solidification localisée pour former du germanium monocristallin, à partir d'une zone de germe en silicium monocristallin formée sur une face avant d'un substrat massif en silicium. Ainsi, Yaocheng Liu et al., dans l'article « High-quality single-crystal Ge on insulator by liquid-phase epitaxy on Si Substrates (Applied Physics Letters, Vol 84, N°14, pages 2563-2565) proposent de réaliser, avec la méthode de solidification localisée, un substrat de type germanium sur isolant (GeOl), c'est-à-dire un empilement comportant successivement un film mince de germanium monocristallin, une couche mince isolante électriquement et un substrat massif en silicium. Le film mince en germanium monocristallin est, en effet, réalisé sur un substrat massif en silicium, muni, sur sa face avant, d'une couche mince isolante électriquement. Une partie de la face avant du substrat massif en silicium est préalablement libérée pour former une zone libre dite zone de germe. Puis, du germanium est déposé par pulvérisation et un traitement thermique rapide permet de porter le germanium à l'état liquide. Le germanium est, ensuite refroidi pour passer à l'état solide, sous forme monocristalline. La solidification est réalisée à partir de la zone de germe créée dans le substrat massif en silicium monocristallin, puis elle se propage latéralement dans le germanium liquide jusqu'à former le film mince en germanium monocristallin.

Par contre, la méthode de solidification localisée employée dans le mode particulier de réalisation selon l'invention est utilisée pour réaliser un substrat hybride, c'est-à-dire pour réaliser sur la face avant d'un support des premières et secondes zones actives semi-conductrices distinctes. Les secondes zones actives sont réalisées par solidification localisée, à partir de régions d'interface, dites régions de germe, d'une paroi latérale de premières zones actives présélectionnées parmi les premières zones actives préalablement formées. Ceci permet, notamment, aux faces avant des premières et des secondes zones actives d'être dans un même plan et donc d'être coplanaires.

Ainsi, les figures 1 à 10 illustrent un mode particulier de réalisation de l'invention consistant à former, sur la face avant d'un support, des premières zones actives en silicium monocristallin et des secondes zones actives en germanium monocristallin. De plus, les premières zones actives sont réalisées à partir d'un substrat de type silicium sur isolant 1 (SOI) tel que celui représenté sur la figure 1. Le substrat de type SOI 1 comporte un empilement comprenant un film mince 2 en silicium monocristallin, une couche mince 3 isolante électriquement et un substrat 4.

Le film mince 2 a, de préférence, une épaisseur comprise entre quelques nanomètres et quelques micromètres et, plus particulièrement, comprise entre 10 nm et 100 nm. Le substrat 4 est, par exemple, en silicium. Il peut également être constitué par tout autre type de matériau classiquement utilisé pour former des substrats de type SOI 1. Par ailleurs, le substrat 4 a, de préférence, un temps caractéristique de mise à l'équilibre thermique plus faible que celui de la couche mince 3 isolante électriquement.

La couche mince 3 isolante électriquement est également appelée couche enterrée. Comme représentée sur la figure 1, elle est disposée entre le film mince 2 et le substrat 4. Ainsi, elle comporte une face avant 5a, de préférence, plane et en contact avec le film mince 2 et une face arrière 5b en contact avec le substrat 4. La face avant 5a constitue alors la face avant du support sur lequel sont réalisées les premières et secondes zones actives. L'épaisseur de la couche mince 3 est, de préférence, comprise entre quelques nanomètres et quelques micromètres.

Plus particulièrement, la couche mince 3 est constituée par un matériau amorphe de manière à éviter, lors d'une étape ultérieure du procédé, une germination intempestive du germanium, à partir de la face avant 5a de la couche mince 3. La couche mince 3 peut, par exemple, être constituée par une couche mince en nitrure de silicium amorphe ou en dioxyde de silicium amorphe. Elle peut également être constituée par un bicouche constitué d'une couche mince en nitrure de silicium amorphe et d'une couche mince en dioxyde de silicium amorphe. Elle peut également comprendre d'autres matériaux ou bien être constitué par un empilement multicouche, dès lors que le matériau destiné à être en contact avec du germanium ne provoque pas ultérieurement sa germination. Ainsi, la face avant 5a de la couche mince 3 est, de préférence, stable chimiquement par rapport au germanium. De plus, le ou les matériaux formant la couche mince 3 sont, de préférence, choisis de manière à ce que le temps caractéristique de mise à l'équilibre thermique de la couche mince 3 soit supérieur à celui caractérisant le germanium. En première approximation, ledit temps caractéristique correspond à la formule généraie : τᵢ = lᵢ²/(kᵢ/(ρᵢ×Cᵢ) avec i correspondant à la référence de la couche considérée (par exemple i = 3 pour la couche mince 3 isolante diélectrique), lᵢ correspondant à une longueur caractéristique de la couche i. kᵢ, ρᵢ et Cᵢ correspondent, respectivement, à la conductivité thermique, à la densité et à la capacité calorifique du matériau constituant la couche i. Ainsi, pour la couche mince 3, l₃ correspond à l'épaisseur de la couche mince 3 et pour un motif i en germanium polycristallin et/ou amorphe, lᵢ correspond à la largeur dudit motif.

Comme illustré sur les figures 1 et 2, les premières zones actives sont réalisées dans le film mince 2 du substrat de type SOI 1. Elles sont, plus particulièrement, réalisées par photolithogravure du film mince 2, à travers un masque en résine (non représenté) avant que celui-ci ne soit retiré. Ainsi, sur la figure 2, trois premières zones actives 1a, 1b et 1c sont représentées. Elles sont séparées les unes des autres par deux espaces 6a et 6b libérant des parties de la face avant 5a de la couche mince 3. Les premières zones 1a, 1b et 1c comportent chacune une face avant et une paroi latérale. Ainsi, la première zone 1a comporte une face avant 7a et une paroi latérale 8a, la première zone 1b comporte une face avant 7b et une paroi latérale 8b et la première zone 1c comporte une face avant 7c et une paroi latérale 8c.

Sur la figure 3, une couche de protection 9 est déposée uniformément de manière à recouvrir les faces avant 7a, 7b et 7c et les parois latérales 8a, 8b et 8c des premières zones actives 1a, 1b et 1c. Le fait de déposer uniformément la couche de protection 9 est couramment appelé par l'homme du métier un dépôt conforme. Un dépôt conforme correspond à un dépôt pour lequel la couche de protection présente une épaisseur constante indépendamment de la géométrie de la surface sur laquelle a été réalisé ledit dépôt. La couche de protection 9 recouvre également les parties libres de la face avant 5a de la couche mince 3. La couche de protection 9 est, par exemple, une couche en dioxyde de silicium et elle peut être déposée par tout type de procédé de dépôt sous vide. A titre d'exemple, le procédé de dépôt peut être un procédé de dépôt physique en phase vapeur (PVD) tel qu'un dépôt physique en phase vapeur assisté par plasma (PECVD) ou un procédé de dépôt chimique en phase vapeur (CVD). Selon une alternative, la couche de protection 9 peut aussi être obtenue par oxydation thermique du silicium. La couche de protection 9 peut également être constituée d'un empilement de plusieurs couches minces dès lors que la couche mince destinée à être en contact avec du germanium ne provoque pas ultérieurement sa germination.

La couche de protection 9 est, ensuite structurée de manière à libérer, dans les parois latérales de premières zones actives présélectionnées, des régions appelées régions d'interface et correspondant à des régions dites de germe. La structuration est, par exemple, réalisée par une étape de photolithographie suivie d'une étape de gravure. La structuration est, plus particulièrement, réalisée au moyen d'une couche en résine photosensible déposée sur la couche de protection 9. La couche en résine photosensible est ensuite insolée et révélée de manière à former un masque recouvrant une partie de la couche de protection 9. La partie de la couche de protection 9 non recouverte par le masque correspond alors à la partie libérée de la couche de protection 9. La partie libérée de la couche de protection 9 est, alors éliminée par gravure tandis que la partie de la couche de protection 9 recouverte par le masque reste protégée. Le masque est ensuite retiré. La gravure est, par exemple, une gravure chimique. A titre d'exemple, une couche de protection en Si₃N₄ peut être gravée avec une solution d'acide ortho-phosphorique H₃PO₄ et, pour une couche de protection en SiO₂, la gravure peut être réalisée avec une solution d'acide fluorhydrique. De plus, si la couche de protection 9 est constituée d'un empilement de deux couches, respectivement en SiO₂ et en Si₃N₄, et si la couche en SiO₂ est en contact avec les premières zones actives 1a, 1b et 1c, ladite couche en SiO₂ peut servir de barrière d'arrêt à la gravure de la couche en Si₃N₄ réalisée au moyen d'une solution riche en H₃PO₄.

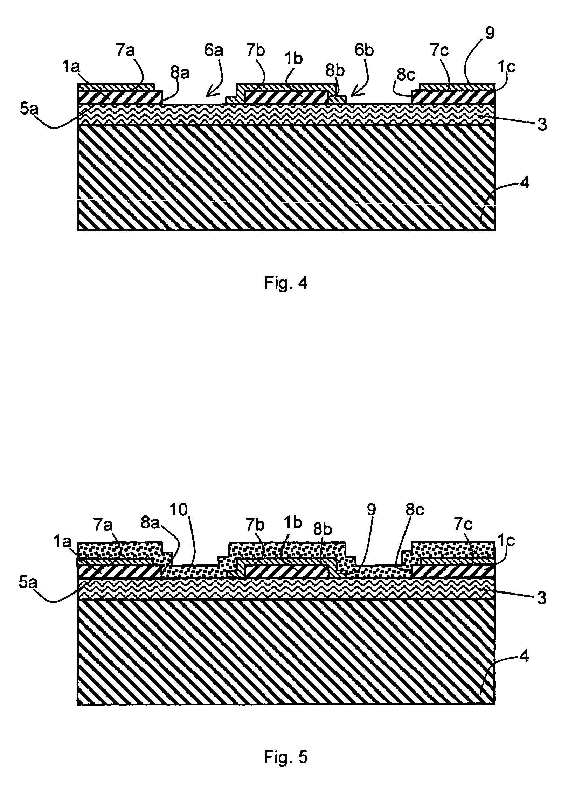

Sur la figure 4, la structuration de la couche de protection 9 a été réalisée de manière à libérer des régions d'interface dans les parois latérales 8a et 8c, respectivement des premières zones 1a et 1c. La paroi latérale 8b de la première zone 1b reste, quant à elle, protégée par la couche de protection 9. De plus, les deux régions d'interface libérées correspondent chacune à la partie de la paroi latérale 8a ou 8b de la première zone active présélectionnée correspondante 1a ou 1c, délimitant un espace 6a ou 6b.

Dans le mode de réalisation représenté sur la figure 4, les faces avant 7a, 7b et 7c des premières zones actives 1a, 1b et 1c restent en partie recouvertes par la couche de protection 9. Par contre, la structuration de la couche de protection 9 permet de libérer au moins partiellement les parties de la face avant 5a de la couche mince 3 qui délimitent les espaces 6a et 6b. Ceci conduit à la formation des éléments barrière 9a et 9b destinés à protéger la paroi latérale d'une première zone active non présélectionnée.

La libération au moins partielle desdites parties de la face avant 5a de la couche mince 3 n'est possible que si les matériaux constituant respectivement la couche de protection 9 et la couche mince 3 sont différents et que la gravure de la couche de protection 9 est sélective par rapport au(x) matériau(x) constituant la couche mince 3. C'est, par exemple, le cas si la couche mince 3 est en Si₃N₄, la couche de protection 9 est en SiO₂ et si la gravure de la couche de protection 9 est réalisée avec une solution d'acide fluorhydrique. Dans d'autres cas, la structuration de la couche de protection 9 pourrait s'arrêter ou être arrêtée avant d'atteindre l'interface entre la couche de protection 9 et la couche mince 3. Elle pourrait également être poursuivie dans la couche mince 3. L'épaisseur du matériau de la couche mince 3 consommé correspondrait alors à l'épaisseur de la sur-gravure par rapport à une gravure dite idéale et correspondant à un arrêt de gravure à l'interface entre la couche de protection 9 et la couche mince 3.

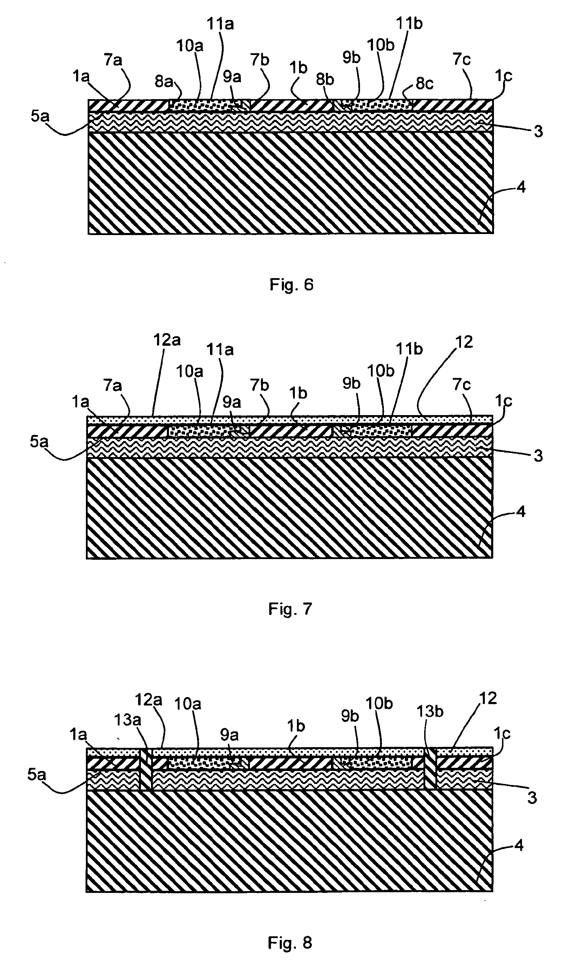

Comme illustré sur la figure 6, des motifs 10a et 10b en germanium polycristallin et/ou amorphe sont, ensuite, intercalés entre lesdites premières zones actives 1a, 1b et 1c, sur les parties libres de la face avant 5a de la couche mince 3. Chaque motif 10a, 10b présente une face avant 11a, 11b dans le même plan que les faces avant 7a, 7b et 7c des premières zones actives 1a, 1b et 1c et il comporte au moins une partie d'une paroi latérale en contact direct avec la région d'interface d'une première zone active présélectionnée adjacente. Ainsi, sur la figure 6, une partie de la paroi latérale du motif 10a est en contact direct avec la région d'interface de la première zone active 1a tandis que, pour le motif 10b, une partie de sa paroi latérale est en contact direct avec la région d'interface de la première zone active 1c. Les autres parties des parois latérales des motifs 10a et 10b sont, quant à elles, séparées, des parois latérales des premières zones actives, par des éléments barrières 9a et 9b formés par une partie restante de la couche de protection 9.

Comme représenté sur la figure 5, cette intercalation est, par exemple, réalisée en déposant uniformément (dépôt conforme) une couche 10 en germanium sous forme polycristalline et/ou amorphe, sur l'ensemble de la surface libre de la structure représentée à la figure 4. Le dépôt conforme est, par exemple, réalisé par dépôt physique en phase vapeur ou dépôt chimique en phase vapeur.

Selon un mode particulier de réalisation, le dépôt conforme peut être réalisé en deux étapes de dépôt distinctes. La première étape, par exemple un dépôt PECVD, peut permettre d'amorcer uniformément le dépôt de germanium tandis que la seconde étape peut être une étape de dépôt plus standard et moins coûteuse, par exemple une étape de type CVD ou PVD. Cette seconde étape permet de compléter le dépôt jusqu'à l'épaisseur souhaitée pour la couche 10. Dans ce mode particulier, la couche 10 est alors constituée de deux sous-couches superposées, la première étant amorphe et la seconde étant polycristalline. Avec ce mode particulier de réalisation, la première sous-couche amorphe forme, sur la surface libre de la structure telle que représentée sur la figure 4, une couche dite de mouillage présentant l'avantage d'être uniforme quel que soit le matériau constituant la surface sur laquelle elle est déposée. Le dépôt de la deuxième sous-couche se fait alors sans difficulté car le dépôt de la première sous-couche évite le problème de barrière à la nucléation, susceptible de se produire lors du dépôt d'un matériau quelconque sur une surface de nature différente.

Cette étape de dépôt conforme est, ensuite, suivie d'une étape de planarisation, telle qu'un polissage mécano-chimique (CMP). Cette étape de planarisation permet d'obtenir les motifs 10a et 10b tels que représentés sur la figure 6. Plus particulièrement, elle permet aux faces avant 11a et 11 b des motifs 10a et 10b d'être dans le même plan que les faces avant 7a, 7b et 7c. Ainsi, dans le mode de réalisation représenté à la figure 5, l'épaisseur de la couche 10 étant égale à l'épaisseur des premières zones actives 1a, 1b et 1c, le polissage mécano-chimique sera réalisé de manière à n'éliminer que les parties de la couche 10 disposées sur les faces avant 7a, 7b et 7c. Ainsi, le polissage ne s'arrête qu'une fois la couche de protection 9 atteinte. Préférentiellement, il ne s'arrête qu'à l'interface entre la couche de protection 9 et les premières zones actives 1a, 1b et 1c, libérant ainsi les faces avant 7a, 7b et 7c (figure 6). Les moyens pour déterminer le moment d'arrêt de la gravure sont bien connus de l'homme du métier. A titre d'exemple, l'homme du métier pourra utiliser un système de détection de fin d'attaque ou une méthode de mesure de la variation du couple exercé sur le moteur de la polisseuse, en fonction de la nature des matériaux.

Une couche de passivation 12, relativement épaisse et rigide, est ensuite déposée sur la surface libre plane de la structure représentée sur la figure 6, c'est-à-dire sur les faces avant 7a, 7b et 7c des premières zones actives et sur les faces avant 11a et 11b des motifs 10a et 10b (figure 7). Par ailleurs, le matériau de la couche de passivation 12, destiné à être en contact avec les faces avant 11a et 11b des motifs 10a et 10b de germanium est, de préférence, amorphe. La couche de passivation 12 assure notamment la protection des premières zone actives 1a, 1b et 1c et des motifs 10a et 10b, contre l'environnement extérieur, notamment lors d'étapes à haute température.

Préférentiellement, sur la figure 8, des passages transversaux sont formés entre le substrat 4 et la face avant 12a de la couche de passivation 12. Les passages transversaux sont formés de manière à traverser la couche mince 3 et les premières zones actives 1a et 1c, à proximité des régions d'interface. Puis, les passages sont remplis par un matériau conducteur thermique de manière à former des puits thermiques 13a et 13b. Selon une alternative, les puits thermiques 13a et 13b peuvent être formés avant le dépôt de la couche de passivation 12. Dans ce cas, des passages transversaux sont formés entre les premières zones actives comportant des régions d'interface, c'est-à-dire les premières zones actives 1a et 1c sur la figure 5, et le substrat 4.

Le matériau conducteur thermique remplissant les passages transversaux peut être du silicium monocristallin. Le remplissage des passages transversaux est alors, de préférence, réalisé par dépôt sous vide, par exemple par dépôt PVD, CVD ou LPCVD ou bien par épitaxie. Le matériau conducteur thermique peut, également, être un autre matériau que le matériau formant les premières zones actives. Dans ce cas, il est choisi de manière à avoir une conduction thermique élevée et, de préférence, supérieure ou égale à celle des premières zones actives. Il est également non contaminant, c'est-à-dire qu'il ne doit pas modifier les propriétés semi-conductrices des premières zones actives ni faire perdre le caractère d'isolant électrique de la couche mince 3. De plus, le matériau remplissant les passages transversaux peut être choisi de manière à ne pas engendrer de défauts cristallins dans les premières zones actives 1a, 1b et 1c. Préférentiellement, le matériau conducteur thermique est choisi de manière à avoir des propriétés thermiques et thermoélastiques les plus proches possibles de celles du matériau formant les premières zones actives 1a, 1b et 1c.

Les motifs 10a et 10b sont ensuite cristallisés, par solidification localisée. Ainsi, la structure telle que représentée sur la figure 8 subit un traitement thermique destiné à porter les motifs 10a et 10b à une température comprise entre les températures de fusion du germanium et du silicium. La température de fusion du germanium étant de 937°C tandis que celle du silicium est de l'ordre de 1414°C, le traitement thermique est, par exemple, réalisé à une température de l'ordre 950°C, pendant un temps très court. Ceci permet de faire fondre les motifs 10a et 10b de germanium tout en conservant les premières zones actives sous forme solide et en évitant que les matériaux présentant un comportement visqueux aient le temps de se déformer de manière irréversible.

La couche de passivation 12 assure, lors de la mise en fusion du germanium, un rôle de protection mécanique et d'isolation thermique. Elle est, par ailleurs, suffisamment épaisse et rigide. Cela évite qu'elle ne se bombe sous l'effet d'une montée en pression susceptible de se produire lors de la fusion du germanium et que le flux de chaleur susceptible de s'évacuer par sa face libre, par convection et/ou rayonnement n'induise un refroidissement plus rapide que celui devant se produire à travers le substrat 4. La couche de passivation 12 est, par exemple, en dioxyde de silicium, en nitrure de silicium et/ou en dioxyde d'hafnium.

De plus, le mode de chauffage utilisé pour réaliser le traitement thermique est, de préférence, choisi de manière à porter le germanium polycristallin et/ou amorphe à une température supérieure à sa température de fusion tout en s'assurant que le substrat 4 reste une masse thermique froide. Ainsi, préférentiellement, la structure telle que représentée sur la figure 8 est chauffée par la face avant 12a de la couche de passivation 12. Le chauffage peut être réalisé par rayonnement. Dans ce cas, la longueur d'onde du rayonnement incident est, de préférence, choisie de manière à être absorbée par le ou l'un des matériaux constituant la couche de passivation 12. La couche de passivation 12 permet alors de chauffer par conduction le germanium sous-jacent, de sorte qu'elle constitue une zone de chaleur dans la structure représentée sur la figure 8. Par ailleurs, le temps d'exposition au rayonnement incident est, suffisamment court pour que la pénétration de l'onde thermique n'atteigne qu'une épaisseur négligeable du substrat 4.

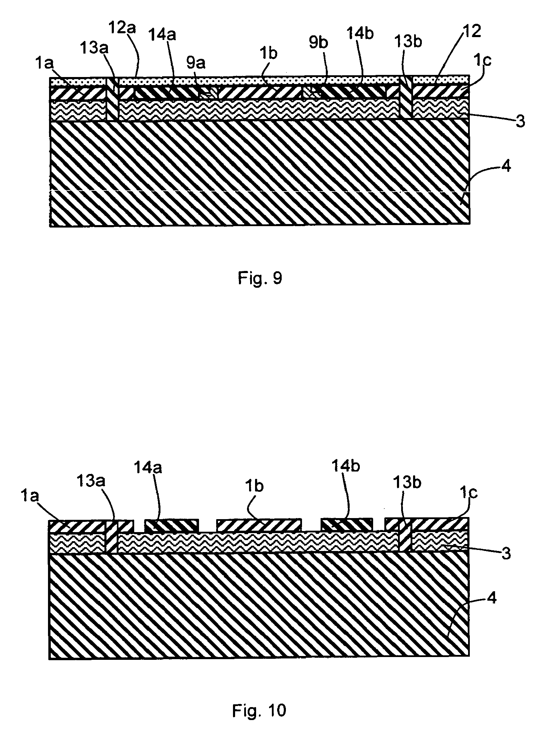

Une fois le traitement thermique terminé, la structure est refroidie, ce qui provoque la solidification, sous forme monocristalline, du germanium et forme donc les seconde zones actives 14a et 14b comme représentées sur la figure 9. Le refroidissement est, par exemple, obtenu par évacuation de la chaleur vers le substrat 4, au moyen des puits thermiques 13a et 13b. Le substrat 4 forme alors un puit de chaleur dans lequel la puissance thermique apportée lors du traitement thermique peut être évacuée pendant l'étape de solidification. Pour que ce puit de chaleur soit efficace, il est, cependant, nécessaire que le mode de chauffage utilisé pendant l'étape de traitement thermique n'ait chauffé que superficiellement ledit substrat et/ou que, lors de l'étape de refroidissement, l'évacuation de la chaleur se fasse principalement vers la face arrière du substrat 4, par l'intermédiaire des puits thermiques 13a et 13b.

Dans ce mode de réalisation, la cristallisation du germanium sous forme monocristalline a lieu par solidification localisée. En effet, la solidification du germanium débute par germination aux régions d'interface, dites régions de germe, des premières zones actives 1a et 1c. Puis, un front de solidification se propage dans le germanium à l'état liquide, sensiblement horizontalement depuis les régions de germe jusqu'aux parois latérales opposées protégées par les éléments barrière 9a et 9b, de manière à obtenir des secondes zones actives 14a et 14b, en germanium monocristallin.

Une fois les secondes zones actives 14a et 14b formées, la couche de passivation 12 peut être retirée, par exemple par gravure ou photolithogravure et les premières et secondes zones actives peuvent être isolées physiquement les unes des autres, par exemple en supprimant les régions de contact entre une première zone active et une seconde zone active adjacente (Figure 9). Ceci permet également de réaliser une isolation électrique entre les premières zones actives et les secondes zones actives.

Selon une alternative au mode de réalisation décrit ci-dessus, la couche de protection 9 n'est pas nécessairement déposée de manière uniforme, telle que représentée sur la figure 3. Elle peut, par exemple, être déposée uniquement sur les parois latérales 8a, 8b et 8c des premières zones actives 1a, 1b et 1c, en formant, par exemple, des espaceurs. Dans ce cas, les faces avant 7a, 7b et 7c des premières zones actives restent libres, jusqu'au dépôt conforme du second matériau semi-conducteur. Une étape de planarisation, par exemple par polissage mécano-chimique (CMP) et/ou par gravure sélective peut, ensuite, être réalisée de manière à supprimer le second matériau semi-conducteur disposé sur la face avant des premières zones actives, avec, de préférence, un arrêt de gravure et/ou de CMP au niveau de la face avant 7a, 7b et 7c des premières zones actives 1a, 1b et 1c.

Selon une autre alternative, la couche de protection 9 peut être déposée de manière uniforme, telle que représentée sur la figure 3, mais la structuration de la couche de protection 9 peut être réalisée de manière à libérer également les faces avant 7a, 7b et 7c des premières zones actives 1a, 1b et 1c et au moins partiellement les parties de la face avant de la couche mince 3 qui délimitent également les espaces 6a et 6b. Dans ce cas, la structuration de la couche de protection 9 conduit directement à la formation dans chaque espace 6a et 6b des éléments barrière 9a et 9b représentés sur la figure 6 et destinés à protéger les parois latérales des premières zones actives non présélectionnées.

De plus, une étape intermédiaire de planarisation peut être réalisée entre l'étape de structuration de la couche de protection 9 et l'étape d'intercalation entre les premières zones actives des motifs 10a et 10b. Cette étape intermédiaire peut être réalisée par gravure, avec arrêt à l'interface entre la couche de protection 9 et les premières zones actives ou bien elle peut se poursuivre dans les premières zones actives. Dans ce cas, l'épaisseur des premières zones actives est réduite et une étape de planarisation peut être nécessaire après la formation des motifs 10a et 10b, de manière à ce que les faces avant 11a et 11b des motifs 10a et 10b restent dans le même plan que les faces avant des premières zones actives.

Dans un autre mode de réalisation, la structuration de la couche de protection 9 est réalisée de manière à libérer les parties de la face avant 5a de la couche mince 3 qui délimitent les espaces 6a et 6b. Ceci peut être réalisé, soit à arrêtant la structuration à l'interface entre la couche de protection 9 et la couche mince 3, soit en prolongeant la structuration dans la couche mince 3. Dans ce cas, l'étape d'intercalation de motifs en second matériau semi-conducteur polycristallin et/ou amorphe, entre les premières zones actives, est, de préférence, réalisée par dépôt sélectif du second matériau semi-conducteur, uniquement dans les espaces 6a et 6b. A titre d'exemple, dans une structure telle que représentée sur la figure 4, la couche mince 3 est en Si₃N₄, la couche de protection 9 est en SiO₂ et les premières zones actives 1a, 1b et 1c sont en alliage de silicium et de germanium. Un dépôt chimique en phase vapeur est réalisé de manière sélective pour former directement des motifs 10a et 10b en second matériau semi-conducteur dans des espaces 6a et 6b. Le second matériau semi-conducteur présente une température de fusion inférieure à celle de l'alliage de silicium et de germanium. Si nécessaire, une étape de planarisation peut être mise en oeuvre après la formation des motifs 10a et 10b de manière à obtenir une structure telle que celle représentée sur la figure 6.

L'invention n'est pas limitée aux modes de réalisation décrits ci-dessus.

Plus particulièrement, la forme des premières et des secondes zones actives peut être quelconque. La forme des premières et des secondes zones actives peut, par exemple, être choisie de manière à piéger les défauts cristallins susceptibles de se former pendant l'étape de cristallisation du germanium.

De plus, le silicium monocristallin peut être remplacé par tout type de matériau semi-conducteur monocristallin ayant une structure cristalline permettant de réaliser du germanium ou un autre matériau semi-conducteur monocristallin grâce à une étape de cristallisation localisée au niveau d'une région d'interface disposée dans la paroi latérale des premières zones actives. A titre d'exemple, le silicium monocristallin peut être remplacé par un alliage de silicium et de germanium (SiGe) ou bien, si le premier matériau semi-conducteur est du silicium monocristallin, le germanium peut être remplacé par un alliage de silicium et de germanium.

Pour réaliser la cristallisation du second matériau semi-conducteur, la méthode de solidification localisée ou épitaxie en phase liquide (LPE) peut être remplacée par une méthode d'épitaxie en phase solide, également connue sous le nom anglo-saxon Solid-Phase Epitaxy (SPE). Dans ce cas, une étape de cristallisation en phase solide est réalisée après le dépôt de la couche de passivation 12, de manière à former, au niveau des régions d'interface, un monocristal qui va croître par répétition de plusieurs cycles de cristallisation jusqu'à ce que les motifs 10a et 10b soient totalement transformés en monocristal et forment les secondes zones actives 14a et 14b. Le second matériau semi-conducteur n'a alors pas besoin d'avoir une température de fusion inférieure à celle du premier matériau semi-conducteur.

Le matériau formant le substrat 4 peut être identique ou différent du matériau constituant le film mince 2.

Un procédé selon l'invention présente l'avantage de simplifier la fabrication d'un substrat hybride, utilisé, en particulier, pour la fabrication de structure de type C-MOS. En effet, le procédé de réalisation décrit ci-dessus peut être utilisé pour la fabrication de structures de type C-MOS, des transistors n-MOS étant formés dans des premières zones actives en silicium monocristallin et des transistors p-MOS étant formés dans des secondes zones actives en germanium monocristallin. Il permet donc de traiter collectivement la fabrication de transistors n-MOS et p-MOS sur un même support, ce qui réduit les coûts de réalisation. En effet, le germanium, connu pour améliorer les performances des transistors MOS, est, cependant très cher. L'intégrer sur un support comportant également des zones actives en silicium permet de réduire le coût du support initial.

## Revendications

1. Procédé de réalisation sur la face avant d'un support de premières et secondes zones actives (1a, 1b, 1c et 14a, 14b), respectivement constituées par des premier et second matériaux semi-conducteurs monocristallins distincts et comportant des faces avant coplanaires, procédé dans lequel le support est constitué d'un empilement d'un substrat (4) et d'une couche mince (3) isolante électriquement, la face avant (5a) de la couche mince (3) isolante électriquement constituant la face avant du support, le procédé comportant au moins les étapes successives suivantes :
- formation, sur la face avant (5a) de la couche mince (3) isolante électriquement, des premières zones actives (1a, 1b, 1c) dont au moins les parois latérales (8a, 8b, 8c) sont recouvertes par une couche mince de protection (9),
- structuration de la couche mince de protection (9) de manière à libérer des régions d'interface dans les parois latérales (8a, 8c) de premières zones actives présélectionnées (1a, 1 c),
- intercalation entre les premières zones actives (1a, 1b, 1c), sur la face avant (5a) de la couche mince (3) isolante électriquement, de motifs (10a, 10b) en second matériau semi-conducteur sous forme polycristalline et/ou amorphe, chaque motif (10a, 10b) comportant au moins une partie d'une paroi latérale en contact direct avec une région d'interface d'une première zone active présélectionnée adjacente (1a, 1c) et une face avant (11a, 11 b) disposée dans le même plan que les faces avant (7a, 7b, 7c) des premières zones actives (1a, 1 b, 1 c),
- dépôt d'une couche de passivation (12) sur les premières zones actives (1 a, 1b, 1 c) et les motifs (10a, 10b),
- et cristallisation du second matériau semi-conducteur sous forme monocristalline, de manière à former les secondes zones actives (14a, 14b).

2. Procédé selon la revendication 1, **caractérisé en ce que** la cristallisation est réalisée par une étape de solidification localisée.

3. Procédé selon la revendication 2, **caractérisé en ce que** la cristallisation localisée comporte :
- le traitement thermique à une température prédéterminée comprise entre les températures de fusion respectives des premier et second matériaux, le second matériau ayant une température de fusion inférieure à celle du premier matériau
- et la solidification du second matériau semi-conducteur sous forme monocristalline, de manière à former les secondes zones actives (14a, 14b).

4. Procédé selon la revendication 1, **caractérisé en ce que** la cristallisation est réalisée par épitaxie en phase solide.

5. Procédé selon l'une quelconque des revendications 1 à 4, **caractérisé en ce que** le substrat (4) est en premier matériau semi-conducteur monocristallin.

6. Procédé selon l'une quelconque des revendications 1 à 5, **caractérisé en ce que** la cristallisation étant réalisée par une étape de solidification localisée, le substrat (4) a un temps caractéristique de mise en équilibre thermique plus faible que celui de la couche mince (3) isolante électriquement.

7. Procédé selon la revendication 6, **caractérisé en ce que** le procédé comporte avant ladite étape de solidification localisée :
- une étape de formation de passages transversaux entre le substrat (4) et les premières zones actives présélectionnées (1a, 1c), à proximité des régions d'interface desdites premières zones actives présélectionnées (1a, 1 c),
- et une étape de remplissage desdits passages transversaux par un matériau conducteur thermique.

8. Procédé selon la revendication 7, **caractérisé en ce que** le matériau conducteur thermique remplissant lesdits passages transversaux est le premier matériau semi-conducteur monocristallin.

9. Procédé selon l'une quelconque des revendications 1 à 8, **caractérisé en ce que** la cristallisation du second matériau semi-conducteur sous forme monocristalline est suivie d'une étape de retrait de la couche de passivation (12) et d'une étape d'isolation entre les premières et secondes zones actives (1a, 1 b, 1 c et 14a, 14b).

10. Procédé selon l'une quelconque des revendications 1 à 9, **caractérisé en ce que** les premier et second matériaux ont une structure cristalline identique.

11. Procédé selon l'une quelconque des revendications 1 à 10, **caractérisé en ce que** le premier matériau est choisi parmi le silicium et un alliage de silicium et de germanium.

12. Procédé selon l'une quelconque des revendications 1 à 11, **caractérisé en ce que** le second matériau est choisi parmi le germanium et un alliage de silicium et de germanium.

13. Procédé selon l'une quelconque des revendications 1 à 12, **caractérisé en ce que** la face avant du support est stable chimiquement par rapport au second matériau.

14. Utilisation d'un procédé selon l'une quelconque des revendications 1 à 13 pour la fabrication de structures de type C-MOS, utilisation dans laquelle les premières et secondes zones actives (1a, 1b, 1c et 14a, 14b) sont respectivement en silicium et en germanium, des transistors n-MOS sont formés dans les premières zones actives (1a, 1b, 1c) et des transistors p-MOS sont formés dans les secondes zones actives (14a, 14b).

## Patentansprüche

1. Verfahren zum Herstellen von ersten und zweiten aktiven Zonen (1a, 1b, 1c und 14a, 14b) auf der Vorderseite eines Trägers, welche aus einem ersten bzw. zweiten unterschiedlichen, monokristallinen Halbleitermaterial bestehen und komplanare Vorderseiten aufweisen, wobei in dem Verfahren der Träger aus einer Substratschichtung (4) und einer elektrisch isolierenden Dünnschicht (3) besteht, wobei die Vorderseite (5a) der elektrisch isolierenden Dünnschicht (3) die Vorderseite des Trägers bildet, wobei das Verfahren zumindest die folgenden aufeinanderfolgenden Schritte umfasst:
Ausbilden von ersten aktiven Zonen (1a, 1b, 1c) auf der Vorderseite (5a) der elektrisch isolierenden Dünnschicht (3), wobei zumindest die Seitenwände (8a, 8b, 8c) dieser Zonen mit einer dünnen Schutzschicht (9) bedeckt sind,
- Strukturieren der dünnen Schutzschicht (9) derart, dass die Grenzschichtbereiche in den Seitenwänden (8a, 8c) von ersten aktiven vorausgewählten Zonen (1a, 1c) freigesetzt werden,
- Einschieben von Mustern (10a, 10b) aus einem zweiten Halbleitermaterial in polykristalliner und/oder amorpher Form zwischen die ersten aktiven Zonen (1a, 1b, 1c) auf der Vorderseite (5a) der elektrisch isolierenden Dünnschicht (3), wobei jedes Muster (10a, 10b) zumindest einen Teil einer Seitenwand in direktem Kontakt mit einem Grenzschichtbereich einer ersten vorausgewählten, angrenzenden aktiven Zone (1a, 1c) und eine Vorderseite (11a, 11b) umfasst, die in derselben Ebene wie die Vorderseiten (7a, 7b, 7c) der ersten aktiven Zonen (1a, 1b, 1c) angeordnet ist,
- Aufbringen einer Passivierungsschicht (12) auf die ersten aktiven Zonen (1a, 1b, 1c) und die Muster (10a, 10b),
- sowie Kristallisieren des zweiten Halbleitermaterials in monokristalliner Form derart, dass die zweiten aktiven Zonen (14a, 14b) gebildet werden.

2. Verfahren gemäß Anspruch 1, **dadurch gekennzeichnet, dass** die Kristallisierung in einem lokal begrenzten Verfestigungsschritt durchgeführt wird.

3. Verfahren gemäß Anspruch 2, **dadurch gekennzeichnet, dass** die lokal begrenzte Kristallisierung Folgendes umfasst:
- die Wärmebehandlung bei einer vorgegebenen Temperatur zwischen den jeweiligen Schmelztemperaturen des ersten und zweiten Materials, wobei das zweite Material eine niedrigere Schmelztemperatur aufweist als das erste Material
- sowie die Verfestigung des zweiten Halbleitermaterials in monokristalliner Form derart, dass die zweiten aktiven Zonen (14a, 14b) gebildet werden.

4. Verfahren gemäß Anspruch 1, **dadurch gekennzeichnet, dass** die Kristallisierung durch Epitaxie in fester Phase durchgeführt wird.

5. Verfahren gemäß einem der Ansprüche 1 bis 4, **dadurch gekennzeichnet, dass** das Substrat (4) aus dem ersten monokristallinen Halbleitermaterial besteht.

6. Verfahren gemäß einem der Ansprüche 1 bis 5, **dadurch gekennzeichnet, dass** bei Durchführung der Kristallisierung in einem lokal begrenzten Verfestigungsschritt das Substrat (4) eine spezifische Zeit aufweist, in der sich ein Temperaturgleichgewicht einstellt, das niedriger als das der elektrisch isolierenden Dünnschicht (3) ist.

7. Verfahren gemäß Anspruch 6, **dadurch gekennzeichnet, dass** das Verfahren vor dem lokal begrenzten Verfestigungsschritt Folgendes umfasst;
- einen Schritt zur Bildung von querlaufenden Durchlässen zwischen dem Substrat (4) und den ersten vorausgewählten aktiven Zonen (1a, 1c) in der Nähe der Grenzschichtbereiche dieser ersten vorgewählten aktiven Zonen (1a, 1c),
- sowie einen Schritt zum Füllen dieser querlaufenden Durchlässe mit einem wärmeleitenden Material.

8. Verfahren gemäß Anspruch 7, **dadurch gekennzeichnet, dass** das wärmeleitende Material, das diese querlaufenden Durchlässe füllt, das erste monokristalline Halbleitermaterial ist.

9. Verfahren gemäß einem der Ansprüche 1 bis 8, **dadurch gekennzeichnet, dass** auf die Kristallisierung des zweiten Halbleitermaterials in monokristalliner Form ein Schrumpfschritt der Passivierungsschicht (12) sowie ein Isolierschritt zwischen den ersten und zweiten aktiven Zonen (1a, 1b, 1c sowie 14a, 14b) folgt.

10. Verfahren gemäß einem der Ansprüche 1 bis 9, **dadurch gekennzeichnet, dass** das erste und zweite Material eine identische kristalline Struktur aufweisen.

11. Verfahren gemäß einem der Ansprüche 1 bis 10, **dadurch gekennzeichnet, dass** das erste Material aus Silizium und einer Silizium-Germanium-Legierung ausgewählt ist.

12. Verfahren gemäß einem der Ansprüche 1 bis 11, dadurch gekennzeiehnet, dass das zweite Material aus Germanium und einer Silizium-Germanium-Legierung ausgewählt ist.

13. Verfahren gemäß einem der Ansprüche 1 bis 12, **dadurch gekennzeichnet, dass** die Vorderseite des Trägers gegenüber dem zweiten Material chemisch stabil ist.

14. Verwendung eines Verfahrens gemäß einem der Ansprüche 1 bis 13 für die Herstellung von C-MOS Strukturen, bei der die ersten und zweiten aktiven Zonen (1a, 1b, 1c sowie 14a, 14b) aus Silizium bzw. aus Germanium bestehen, n-MOS Transistoren in den ersten aktiven Zonen (1a, 1b, 1c) ausgebildet sind und p-MDS Transistoren in den zweiten aktiven Zonen (14a, 14b) ausgebildet sind.

## Claims

1. Method for producing first and second active zones (1a, 1b, 1c and 14a, 14b) on the front face of a support, which zones are respectively formed by first and second monocrystalline semi-conducting materials that are distinct from one another and comprise coplanar front faces, method wherein the support is formed by stacking of a substrate (4) and of an electrically insulating thin layer (3), the front face (5a) of the electrically insulating thin layer (3) forming the front face of the support, the method comprising at least the following successive steps:
- formation, on the front face (5a) of the electrically insulating thin layer (3), of the first active zones (1a, 1b, 1c), at least the side walls (8a, 8b, 8c) whereof are covered by a thin protective layer (9),
- patterning of the thin protective layer (9) so as to free interface regions in the side walls (8a, 8c) of preselected first active zones (1 a, 1c),
- intercalation between the first active zones (1a, 1b, 1c), on the front face (5a) of the electrically insulating thin layer (3), of patterns (10a, 10b) made of second semi-conducting material in polycrystalline and/or amorphous form, each pattern (10a, 10b) comprising at least a part of a side wall in direct contact with an interface region of an adjacent preselected first active zone (1a, 1c) and a front face (11a, 11b) disposed in the same plane as the front faces (7a, 7b, 7c) of the first active zones (1a, 1 b, 1 c),
- deposition of a passivation layer (12) on the first active zones (1a, 1b, 1c) and the patterns (10a, 10b),
- and crystallization of the second semi-conducting material in monocrystalline form so as to form the second active zones (14a, 14b).

2. Method according to claim 1, **characterized in that** crystallization is achieved by a localized solidification step.

3. Method according to claim 2, **characterized in that** localized crystallization comprises:
- thermal treatment at a preset temperature comprised between the respective melting temperatures of the first and second materials, the second material having a lower melting temperature than that of the first material
- and solidification of the second semi-conducting material in monocrystalline form so as to form the second active zones (14a, 14b).

4. Method according to claim 1, **characterized in that** crystallization is achieved by solid-phase epitaxy

5. Method according to any one of the claims 1 to 4, **characterized in that** the substrate (4) is made of a first monocrystalline semi-conducting material.

6. Method according to any one of the claims 1 to 5, **characterized in that** crystallization being performed by a localized solidification step, the substrate (4) has a lower thermal stabilization characteristic time than that of the electrically insulating thin layer (3).

7. Method according to claim 6, **characterized in that** the method comprises before said localized solidification step:
- a step of forming transverse passages between the substrate (4) and the preselected first active zones (1a, 1c) near the interface regions of said preselected first active zones (1a, 1c),
- and a step of filling said transverse passages with a thermally conducting material.

8. Method according to claim 7, **characterized in that** the heat conducting material filling said transverse passages is the first monocrystalline semi-conducting material.

9. Method according to any one of the claims 1 to 8, **characterized in that** crystallization of the second semi-conducting material in monocrystalline form is followed by a removal step of the passivation layer (12) and by an insulation step between the first and second active zones (1a, 1b, 1c and 14a, 14b).

10. Method according to any one of the claims 1 to 9, **characterized in that** the first and second materials have an identical crystalline structure.

11. Method according to any one of the claims 1 to 10, **characterized in that** the first material is chosen from silicon and a silicon and germanium alloy.

12. Method according to any one of the claims 1 to 11, **characterized in that** the second material is chosen from germanium and a silicon and germanium alloy.

13. Method according to any one of the claims 1 to 12, **characterized in that** the front face of the support is chemically stable with respect to the second material.

14. Use of a method according to any one of the claims 1 to 13 for fabricating of C-MOS structures, use wherein the first and second active zones (1a, 1b, 1c and 14a, 14b) are respectively made of silicon and germanium, n-MOS transistors are formed in the first active zones (1a, 1b, 1c) and p-MOS transistors are formed in the second active zones (14a, 14b).
